(19) Europäisches Patentamt
European Patent Office
Office européen des brevets

(11) **EP 2 489 106 B1**

(12) **EUROPEAN PATENT SPECIFICATION**

(45) Date of publication and mention
of the grant of the patent:
**17.02.2021 Bulletin 2021/07**

(51) Int Cl.:
*H01S 3/10* *(2006.01)*     *H01S 5/02* *(2006.01)*
*H01S 5/022* *(2021.01)*    *H01S 5/10* *(2021.01)*
*H01S 5/024* *(2006.01)*    *H01S 5/14* *(2006.01)*

(21) Application number: **10823920.3**

(22) Date of filing: **12.10.2010**

(86) International application number:
**PCT/US2010/052249**

(87) International publication number:
**WO 2011/046898 (21.04.2011 Gazette 2011/16)**

(54) **METHOD AND SYSTEM FOR HYBRID INTEGRATION OF A TUNABLE LASER**

VERFAHREN UND SYSTEM ZUR HYBRIDEN INTEGRATION EINES EINSTELLBAREN LASERS

PROCÉDÉ ET SYSTÈME POUR INTÉGRATION HYBRIDE D'UN LASER ACCORDABLE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **13.10.2009 US 251143 P**
              **13.10.2009 US 251132 P**

(43) Date of publication of application:
**22.08.2012 Bulletin 2012/34**

(73) Proprietor: **Skorpios Technologies, Inc.
Albuquerque, NM 87109 (US)**

(72) Inventors:
• **DALLESASSE, John M.
Albuquerque, New Mexico 87111 (US)**
• **KRASULICK, Stephen B.
Albuquerque, New Mexico 87111 (US)**
• **KOZLOVSKY, William
Albuquerque, New Mexico 87111 (US)**

(74) Representative: **Diehl & Partner
Patent- und Rechtsanwaltskanzlei mbB
Erika-Mann-Straße 9
80636 München (DE)**

(56) References cited:
**US-A1- 2002 197 013**     **US-A1- 2004 037 342**
**US-A1- 2004 037 342**     **US-A1- 2004 228 384**
**US-A1- 2005 213 618**     **US-A1- 2005 226 284**
**US-A1- 2009 225 796**     **US-B1- 6 192 058**

**Description**

CROSS-REFERENCES TO RELATED APPLICATIONS

This present application claims priority to U.S. Provisional Patent Applications No. 61/251,132 and 61/251,143, filed on October 13, 2009.

BACKGROUND OF THE INVENTION

Advanced electronic functions such as photonic device bias control, modulation, amplification, data serialization and de-serialization, framing, routing, and other functions are typically deployed on silicon integrated circuits. A key reason for this is the presence of a global infrastructure for the design and fabrication of silicon integrate circuits that enables the production of devices having very advanced functions and performance at market-enabling costs. Silicon has not been useful for light emission or optical amplification due to its indirect energy bandgap. This deficiency has prevented the fabrication of monolithically integrated optoelectronic integrated circuits on silicon.

Compound semiconductors such as indium phosphide, gallium arsenide, and related ternary and quaternary materials have been extremely important for optical communications, and in particular light emitting devices and photodiodes, because of their direct energy bandgap. At the same time, integration of advanced electrical functions on these materials has been limited to niche, high-performance applications due to the much higher cost of fabricating devices and circuits in these materials.

Silicon integrated circuits ("ICs") have dominated the development of electronics and many technologies based upon silicon processing have been developed over the years. Their continued refinement led to nanoscale feature sizes that can be critical for making complementary metal oxide semiconductor CMOS circuits. On the other hand, silicon is not a direct bandgap materials. Although direct bandgap materials, including III-V compound semiconductor materials, such as indium phosphide, have been developed, there is a need in the art for improved methods and systems related to photonic ICs utilizing silicon substrates.

Thus, there is a need in the art for improved methods and systems related to hybrid integration of silicon and compound semiconductor devices.

Document US 2004/0037342 A1 discloses a grating-stabilized semiconductor laser comprising a gain medium, an integrated low-index waveguide, and a waveguide grating segment providing optical feedback for laser oscillation.

Document US 2009/0225796 A1 discloses a diffraction grating device including a substrate with a primary surface having plural grating areas that are periodically arranged, a diffraction grating structure providing a chirped grating whose pitch monotonically changes along an axis direction, a core layer that is optically coupled with the diffraction grating structure, and a perturbing layer.

SUMMARY OF THE INVENTION

Embodiments of the present invention relate to the tunable laser of claim 1 and the method of operating a tunable laser of claim 11. Preferred embodiments are defined in the respective depending claims. While the description often refers to embodiments and to the invention, it is to be understood that the invention is defined by the appended claims and that the embodiments of the invention are those which comprise at least all the technical features of independent claim 1 or the method steps of independent claim 11.

Numerous benefits are achieved by way of the present invention over conventional techniques. For example, embodiments of the present invention provide methods suitable for reducing the size and power consumption of optical communications systems, relaxing the requirements for stringent temperature control of the devices, and improving the laser linewidth through minimizing refractive index fluctuations in the device. For example, embodiments of the present invention provide methods and systems suitable for providing a bond with good mechanical strength, good electrical conductivity, sufficient compliance to allow the composite or hybrid bonding of semiconductor materials with different coefficients of thermal expansion with good reliability, and which also has good optical transparency. This combination of benefits allows both electrical and optical functionality across the bonded interface between two or more distinct semiconductor materials. These and other advantages of the invention are described in more detail in conjunction with the text below and attached figures.

BRIEF DESCRIPTION OF THE DRAWINGS

FIG. 1A is a simplified plan view illustrating a hybrid integrated tunable laser according to an embodiment of the present invention;

FIG. 1B is a simplified cross-sectional view illustrating a hybrid integrated tunable laser according to a particular embodiment of the present invention;

FIG. 1C is a simplified cross-sectional view illustrating a hybrid integrated tunable laser according to a specific embodiment of the present invention;

FIG. 2A is a cross-sectional view at cross section A-A' as illustrated in FIG. 1A;

FIG. 2B is a cross-sectional view at cross section B-B' as illustrated in FIG. 1A;

FIG. 3A is a simplified perspective view of a waveguide according to an embodiment of the present invention;

FIG. 3B is a simplified cross-sectional view at a high index portion of the waveguide illustrated in FIG. 3A according to an embodiment of the present invention;

FIG. 3C is a simplified cross-sectional view at a low index portion of the waveguide illustrated in FIG. 3A according to an embodiment of the present invention;

FIG. 3D is a contour plot illustrating a TE mode for the high index portion of the waveguide illustrated in FIG. 3B;

FIG. 3E is a contour plot illustrating a TM mode for the high index portion of the waveguide illustrated in FIG. 3B;

FIG. 3F is a contour plot illustrating a TE mode for the low index portion of the waveguide illustrated in FIG. 3C;

FIG. 3G is a contour plot illustrating a TM mode for the low index portion of the waveguide illustrated in FIG. 3C;

FIG. 4A illustrates a reflectance spectrum for a first modulated grating reflector according to an embodiment of the present invention;

FIG. 4B illustrates a reflectance spectrum for a second modulated grating reflector according to an embodiment of the present invention;

FIG. 4C illustrates an overlay of the reflectance spectra shown in FIG. 4A and FIG. 4B;

FIG. 4D illustrates constructive interference between the reflectance spectra shown in FIG. 4A and FIG. 4B;

FIG. 5A is a plot illustrating operating wavelength as a function of temperature change according to an embodiment of the present invention;

FIG. 5B illustrates wavelength shifting of a reflectance spectrum as a function of index of refraction according to an embodiment of the present invention;

FIG. 6 is a simplified flowchart illustrating a method of operating a hybrid integrated laser according to an embodiment of the present invention;

FIG. 7 illustrates an example of a photodiode with a low stress bond between a III-V substrate and a silicon substrate;

FIG. 8 illustrates a bonded structure according to an embodiment of the present invention;

FIG. 9 illustrates a phase diagram showing alloy stability according to an embodiment of the present invention;

FIG. 10 is a simplified schematic diagram of a compound semiconductor structure bonded to a silicon substrate according to an embodiment of the present invention;

FIGS. 11A-11C are simplified schematic diagrams illustrating bond interfaces according to an embodiment of the present invention;

FIGS. 12A-12B are simplified schematic diagrams illustrating bond interfaces according to another embodiment of the present invention;

FIG. 13 is a simplified flowchart illustrating a method of fabricating a hybrid semiconductor structure according to an embodiment of the present invention; and

FIG. 14 is a simplified flowchart illustrating a method of fabricating a hybrid semiconductor structure according to another embodiment of the present invention.

DETAILED DESCRIPTION OF THE INVENTION

Hybrid integration on silicon is preferable for the commercial deployment of optoelectronic integrated circuits. Silicon is a preferable material for electronic integration. Silicon technology has advanced such that extremely complex electronic functions can be realized very inexpensively. Silicon is also a good material for constructing low loss optical waveguides. However, monolithic integration of light generating or detecting functions has been prevented in silicon because it is an indirect bandgap material. Conversely, compound semiconductor materials, including III-V materials such as indium phosphide are well suited for light generation and detection because of their physical properties such as being direct bandgap materials. These materials are complex material systems with small substrates and relatively (compared to silicon) low yields. As such, constructing devices with a high level of functionality is currently cost prohibitive.

Embodiments of the present invention relate to an apparatus and method for hybrid integration of compound semiconductor devices with tuning elements monolithically integrated onto a silicon base or similar material. Preferably, hybrid integration is the method to overcome the specific deficiencies of silicon and compound semiconductors while capitalizing on their respective strengths. Embodiments of the present invention preferably utilize the complex electronic functionality in available using silicon devices to minimize cost, and the optical functions (e.g., light generation and detection) available using III-V materials to form hybrid integrated systems. Some embodiments of the present invention remove functionality from the III-V material system and transfer such functionality to the silicon system to improve system performance.

Embodiments of the present invention utilize photonic apparatus fabricated using compound semiconductor material systems that are mounted onto silicon integrated circuit platforms and the like. Embodiments of the present invention achieve photonic integration by utilizing a plurality of techniques and apparatus that do not historically rely on a direct energy bandgap, including, but not limited to, waveguides, optical multiplexers, optical demultiplexers, optical modulators, and the like, that can be fabricated using silicon and similar materials. Embodiments of the present invention optionally include, but are not limited to, methods of modifying the refractive index of silicon via current injection or local heating.

Embodiments of the present invention include, but are not limited to, optionally utilizing the laser devices that serve as the initial source of optical energy. In today's dense wavelength division multiplexing ("DWDM") systems, the laser sources are typically fixed-wavelength distributed feedback lasers or tunable lasers. Tunable lasers preferably provide additional flexibility to the optical communications network operators. Some DWDM systems can use lasers with up to 80 different wavelengths. A single tunable laser is capable of tuning to any of those wavelengths. One tunable laser can be inventoried and used to replace any of 80 fixed wavelength lasers, thereby reducing the required inventory levels and the associated costs.

The term "silicon" as used throughout this application includes but is not limited to tetravalent nonmetallic elements and the like. The term "laser" as used throughout the specification includes but is not limited to an acronym for light amplification by stimulated emission of radiation; and/or an optical device that produces an intense monochromatic beam of coherent light. The term "SOI" and/or "Silicon on Insulator" stands for, a type of substrate material as used throughout this specification includes but is not limited to grating and tuning testing. The term "DWDM" and/or "Dense Wavelength Division Multiplexing" as used throughout this application includes but is not limited to a technique utilized by the optical communications industry to maximize system bandwidth while minimizing capital expenditures and operational expenditures. These costs are minimized through the use of DWDM techniques because the system operators can increase their system bandwidth simply by adding another optical wavelength as opposed to needing to deploy additional optical fibers which usually requires significant expense. The term "bandgap" as used throughout this application includes but is not limited to an energy range in a solid where no electron states exist; and/or the energy difference between the top of the valence band and the bottom of the conduction band; and/or the amount of energy required to free an outer shell electron from its orbit about the nucleus to a free state; and/or any combination thereof. The term "photonic integration" as used throughout this application includes but is not limited to the meaning to make into a whole or make part of a whole multiple functions and reduce packaging size by an order of magnitude, for example, while matching the performance of a subsystem built with discrete components. The term "gain media" and interchangeably "gain chip" as used throughout this application includes but is not limited to the source of optical gain within a laser. The gain generally results from the stimulated emission of electronic or molecular transitions to a lower energy state from a higher energy state. The term "InP" or "Indium Phosphide", as used throughout this application is used interchangeably with the phrase "III-V compound semiconductor".

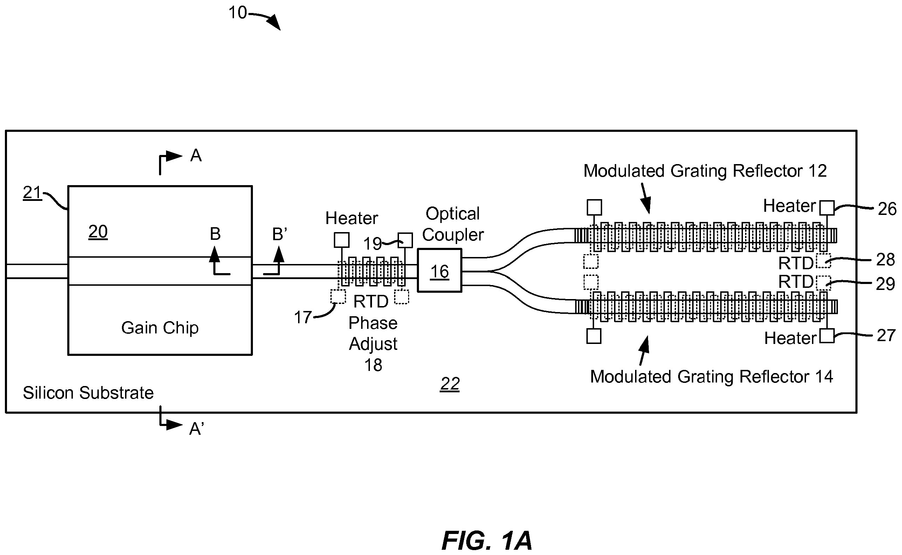

Fig. 1A is a simplified plan view illustrating a hybrid integrated tunable laser according to an embodiment of the present invention. As illustrated in FIG. 1A, laser 10 is a hybrid integrated structure including both active and passive elements disposed on or fabricated in a silicon substrate 22. Although a silicon substrate 22 is illustrated, this is intended to include a variety of semiconductor devices fabricated using the silicon material system. Such devices include CMOS circuitry, current sources, laser drivers, thermal system controllers, passive optical elements, active optical elements, and the like.

Referring to FIG. 1A, a first modulated grating reflector 12 and a second modulated grating reflector 14 are fabricated on the silicon substrate 22. Modulated grating reflectors 12 and 14 are preferably modifiable to adjust the refractive index. The first modulated grating reflector 12 and the second modulated grating reflector 14 are examples of wavelength selective elements that are utilized according to embodiments of the present invention. The illustration of the use of modulated grating reflectors in FIG. 1A is not intended to limit the scope of the present invention but merely to provide examples of wavelength selective elements. Other wavelength selective elements can be utilized in embodiments of the present invention. As described more fully below, the wavelength selective elements can be sampled Bragg gratings or sampled distributed feedback reflectors that provide a comb of reflectance peaks having a variable comb spacing over a tunable wavelength range. Embodiments of the present invention are not limited to these implementations and photonic crystals, etalon structures, MEMS devices, ring resonators, arrayed-waveguide grating devices, Mach-Zehnder lattice filters, and the like can be employed as wavelength selective elements. A benefit provided by the wavelength selective elements discussed herein is a reflection spectra including a single or multiple peaks that can be shifted through the use of a controllable parameter such as current, voltage, temperature, mechanical force, or the like.

As an example, heaters integrated into the silicon substrate can be utilized to locally change the temperature of the region surrounding the modulated grating reflectors and thereby, the index of refraction. As described more fully below, the ability to control the local index of refraction provides the functionality of varying the reflectivity of the modulated grating reflectors and the output wavelength of the hybrid integrated device.

Laser 10 further includes, but is not limited to, multimode interference coupler 16 and one or multiple phase adjustment sections 18. The phase adjustment section 18 can also be referred to as a phase control region that provides for correction of phase misalignment between the output of the coupler section, which may be implemented through wavelength selective devices (e.g., the grating sections) and the gain media 20. In the illustrated embodiment, the phase adjustment section 18 is positioned between the multimode interference coupler 16 and the gain media 20, however, other embodiments locate this element in different locations providing the same or similar performance characteristics.

The coupler section, which may be implemented through the use of a multimode interference coupler, y-branch, or other method, splits and recombines light from two or more tuning sections. The multimode interference coupler, which is based upon the principle that coherent light launched from a waveguide (input waveguide) into a propagation section will self image at periodic intervals, can be used to efficiently achieve n X m splitting ratios. In this instance, the design is optimized for a 1 X 2 split but other splitting ratios may be employed in the case where there are either multiple gain chips or more than 2 tuning arms. An advantage provided by the illustrated device is that coherent light returning from the tuning arms, where the phase relationship of the light is fixed, can be coupled back into the launch waveguide with minimal excess loss. In order to ensure that the interference pattern of the returning light has maximum overlap with the input waveguide, a phase adjustment section may be implemented in one or more of the branch arms. In addition to phase adjustment in the branch arms, a phase adjustment section 18 is utilized in the waveguide section leading from the coupler 16 to the gain chip 20. This phase adjustment section, which can be implemented though a device such as a heater or current injection electrode, which changes the refractive index in the waveguide layer under the device, serves to provide an overlap between the cavity modes of the device and the grating mode selected by tuning section.

As illustrated in FIG. 1A, gain media 20 (also referred to as a gain chip) fabricated using a compound semiconductor material system is integrated with the silicon substrate 22 in a hybrid configuration. The compound semiconductor material, which is direct bandgap, provides optical gain for the laser device. The hybrid integration or attachment of the gain media (and/or other compound semiconductor elements) to the silicon substrate can be provided in one or several manners. In a particular embodiment, the hybrid integration is performed using the methods and systems described in the related application reference in paragraph [0002]. In addition to gain media, absorptive media fabricated using compound semiconductor materials can be integrated with the silicon substrate. Embodiments of the present invention integrate III-V devices and structures acting as gain and/or absorption regions with silicon photonics elements in which optical and/or electrical functionality is provided. The silicon photonic elements may include CMOS circuitry and the like. One of ordinary skill in the art would recognize many variations, modifications, and alternatives.

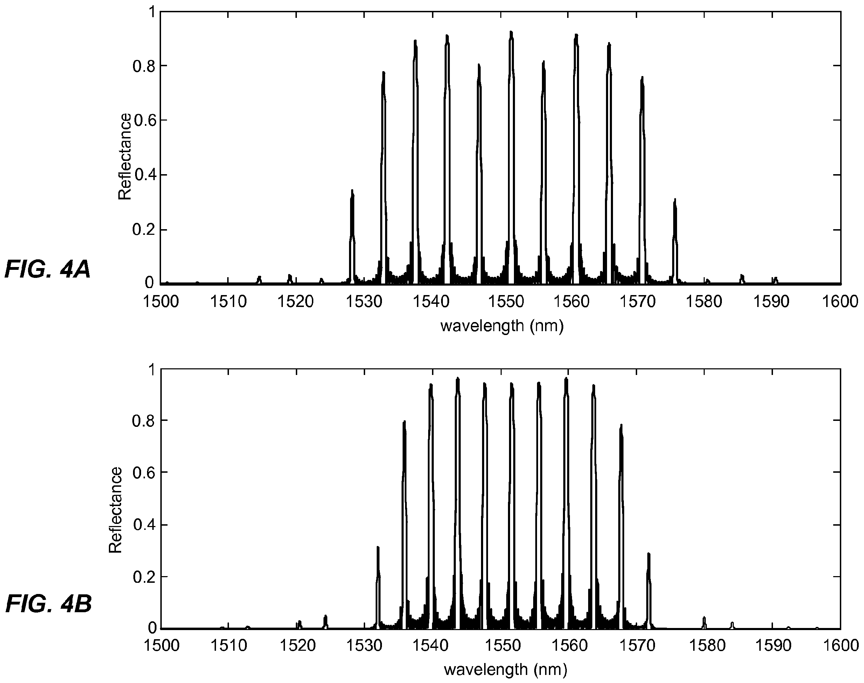

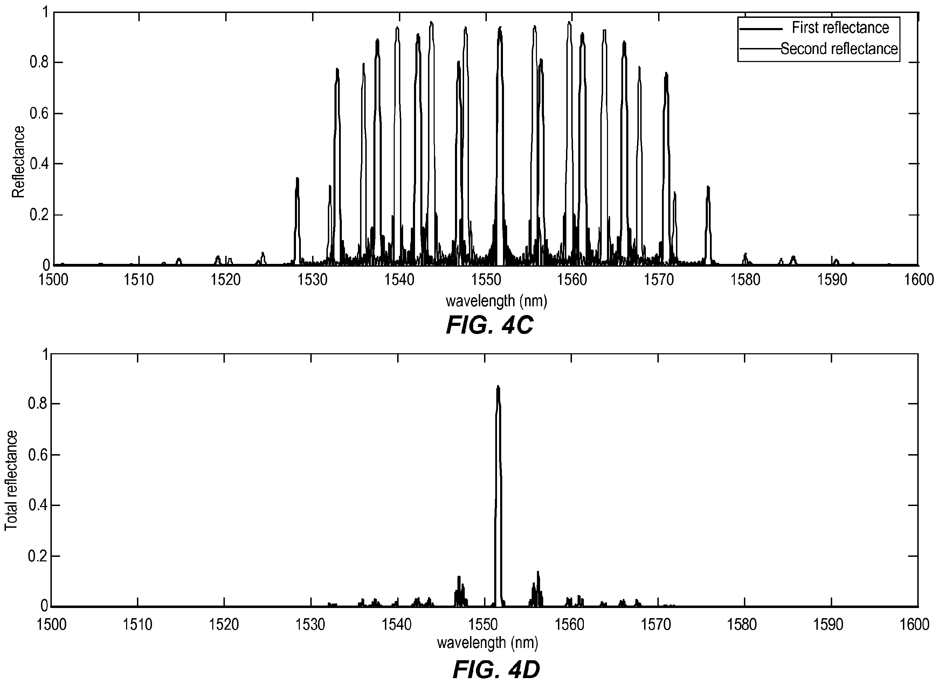

As discussed in more detail in relation to FIGS. 4-4D, modulated grating reflectors 12 and 14 provide feedback at one end of the laser 10. Feedback in the form of a front facet reflector is provided by a low reflectance coating (e.g., a dielectric coating with a reflectance of a few percent, for example, ~1-10%) applied to the gain media on surface 21. Alternatively, a distributed feedback (e.g., a grating) structure could be integrated into the silicon substrate to provide feedback for the laser cavity. In another embodiment, a low reflectance coating is applied to a surface of the silicon substrate. One of ordinary skill in the art would recognize many variations, modifications, and alternatives. As illustrated in FIG. 1A, optical functionality other than optical gain has been transferred from the III-V materials in which it is typically located and integrated into the silicon materials, thereby increasing device yield in comparison with designs that are fully integrated in III-V materials. In the illustrated embodiment, the tunable reflective sections (also referred to as wavelength selective devices) and other optical functions are performed in the silicon material.

FIG. 1A also illustrates heater element 26 and temperature sensor 28 associated with first modulated grating reflector 12 and heater element 27 and temperature sensor 29 associated with the second modulated grating reflector. In an embodiment, the heater element can be a thin film resistor formed through the vacuum deposition of a material such as W, NiCr, TaN, WSi, $RuO_2$, PbO, $Bi_2Ru_2O_7$, $Bi_2Ir_2O_7$, or the like.

In an embodiment, the temperature sensor can be a resistive thermal device (RTD), a thermocouple, a p-n junction, or the like. By flowing a current through the heaters, the temperature of the region surrounding the modulated grating reflectors can be modified in order to modify the index of refraction and the reflectance profile as a result. Phase adjustment section 18, which also may use the temperature dependence of the refractive index to control the effective optical length and thereby the phase of light, is also provided with a heater and a temperature sensor to provide similar functionality and wavelength tunability.

Some embodiments of the present invention utilize thermal tuning to achieve index of refraction changes in the silicon-based modulated grating reflectors. One of the benefits available using thermal tuning is a significant reduction in the short time scale variations in index of refraction that are produced using thermal tuning in comparison to these variations achieved using current tuning in InP material system. Such improvement in refractive index stability will result in a laser linewidth significantly narrower than can be achieved using other approaches. As will be evident to one of skill in the art, the stable tuning provided by embodiments of the present invention enables use of the lasers described herein in DWDM applications and other applications utilizing precisely tuned lasers. As an example, advanced modulation techniques such as DQPSK can benefit from use of the lasers described herein.

The phase adjustment section operates through the modification of the refractive index of the waveguide section contained therein. Through modification of the refractive index, the phase angle of the light exiting the phase adjustment device relative the input phase angle can be precisely controlled. This allows the alignment of laser cavity modes with grating modes. In the illustrated embodiment, the phase adjustment device 18 includes a heater 19 and a temperature sensor (e.g., an RTD) 17.

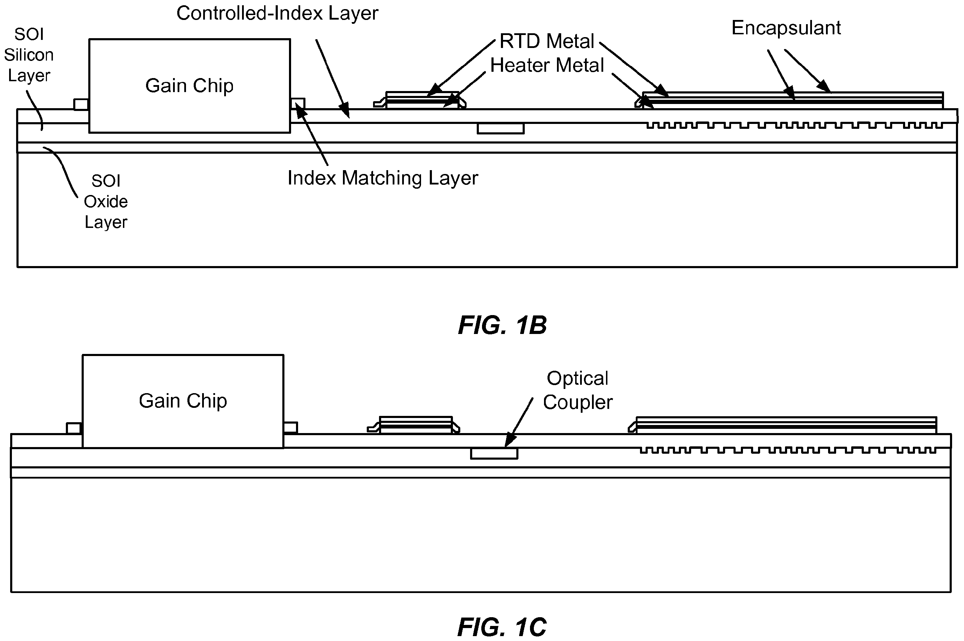

FIG. 1B is a simplified cross-sectional view illustrating a hybrid integrated tunable laser according to a particular embodiment of the present invention. As illustrated in FIG. 1B, direct coupling between the waveguide in the gain media and the waveguide in the silicon layer is utilized. The heater element and the temperature sensor (e.g., an RTD) are illustrated for the phase adjustment section as well as the modulated grating reflector sections. An encapsulant is illustrated over the modulated grating reflector sections. The encapsulant provides for electrical isolation among other features.

FIG. 1C is a simplified cross-sectional view illustrating a hybrid integrated tunable laser according to a specific embodiment of the present invention. The structure illustrated in FIG. 1C is similar to that illustrated in FIG. 1B except that evanescent coupling between the waveguide in the gain media and the waveguide in the silicon layer is utilized.

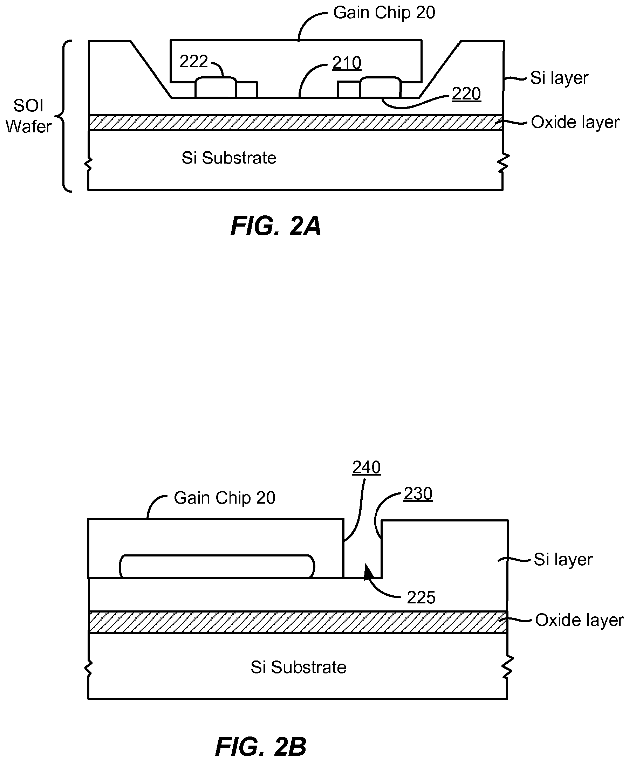

Referring to FIG. 1B, a Controlled Index Layer is illustrated that is not necessarily the same as the index matching layer illustrated in FIG. 2B. The controlled index layer can be used for mode shaping in the silicon waveguide, for example, by using air, SiO$_2$ or the like. According to some embodiments of the present invention, a higher index material is utilized to broaden the mode in the silicon waveguide such that optical coupling to the gain media is improved. If the controlled index layer is not an insulator, an encapsulant layer may also be used between the heater metal and controlled index layer. As illustrated in FIGS. 1B and 1C, either direct coupling (also known as butt coupling) or evanescent coupling of the gain media to the silicon waveguide may be used.

Referring to FIG. 1C, the optical coupler, which may be a device such as a MMI (multimode interference coupler) is illustrated. In some embodiments, an MMI can be formed using an unguided propagation region. Additionally, although not illustrated in FIGS. 1A-1C, a second phase adjust region may be provided in one of the legs of the Y-branched structure in addition to the phase adjustment section illustrated at the output of the tuning section.

FIG. 2A is a cross-sectional view at cross section A-A' as illustrated in FIG. 1A. The silicon substrate 22 is illustrated as well as a silicon-on-insulator (SOI) oxide layer 23 and an SOI silicon layer 24. In the embodiment shown, a portion of the SOI silicon layer has been removed using an etching or other process to provide a recessed region into which the gain chip has been inserted. Such etching may not be performed in the case where evanescent coupling of the light from the gain chip into the silicon waveguide is used. The gain chip is bonded to the silicon substrate in the embodiment illustrated in FIG. 2A using a metal/metal structural bond at locations 25 that provide an electrical bond between the hybrid elements. Additionally, a metal/semiconductor or a semiconductor/semiconductor bond is illustrated. Combinations of these bonding techniques can be implemented as well. One of ordinary skill in the art would recognize many variations, modifications, and alternatives.

FIG. 2B is a cross-sectional view at cross section B-B' as illustrated in FIG. 1A. As will be evident to one of skill in the art, the optical waveguide in the gain chip will be coupled to an optical waveguide in the SOI silicon layer. An index matching region is provided at the interface between the gain chip and the SOI silicon layer to facilitate a high degree of optical coupling between the hybrid devices and to reduce or minimize parasitic reflections. The index matching region can be filled with an appropriate index matching material, remain empty, have optical coatings applied to the surfaces of the hybrid devices as illustrated at facets 26 and/or 27, combinations thereof, or the like.

Referring once again to FIG. 1A first modulated grating reflector 12 provides optical feedback creating a comb of reflected optical wavelengths. Second modulated grating reflector 14 provides optical feedback characterized by a different optical period, thereby resulting in a variable set of reflected wavelengths. The two combs of wavelengths are combined in optical coupler 16. The combs overlap and lasing preferably occurs due to constructive interference. Optionally, where the combs do not overlap, lasing is preferably prevented due to destructive interference. Specific optical spectra of first modulated grating reflector 12 and/or second modulated grating reflector 14 can be modified by varying the refractive index. The refractive index is preferably modified by varying the temperature of the modulated grating reflectors 12, 14 using a heating element. The amount of heating is optionally monitored through use of an RTD element.

Phase adjustment is provided using phase adjustment region 18 to compensate for small phase offsets between the reflection spectra from first modulated grating reflector 12 and the second modulated grating reflector 14. Embodiments of the present invention comprise functional blocks that can be realized in a compound semiconductor such as indium phosphide, and/or silicon and/or similar material. Embodiments of the present invention comprise tuning by modifying the refractive index of the silicon and the like, preferably using a thermal technique.

In embodiments of the present invention, the gain media, which preferably uses a direct-bandgap material, can be realized in a compound semiconductor material. Other embodiments of the present invention include functional blocks that can be realized in silicon material systems. Embodiments of the present invention utilize a hybrid-approach that is preferable for a variety of reasons that include, but are not limited to: manufacturing components using methods that can result in high-yields at low cost; virtually unlimited levels of additional integration can be achieved because of the complexity of the III-V material system as compared to the Si material system, and the like. Therefore, embodiments of the present invention encompass substantially all necessary circuits to control the operation of the tunable laser and can also be monolithically integrated with silicon-based devices.

It should be noted that while embodiments of the present invention have been implemented in relation to products produced by the semiconductor industry, embodiments of the present invention are also useful in optical communications networks for the telecommunications industry, the enterprise communications industry, high-performance computing interconnects, back-plane optical interconnects, chip-to-chip optical interconnects, intra-chip optical interconnects, and the like. In addition to these communication applications, embodiments of the present invention also have applications in the medical device industry.

The following figures illustrate an analysis and applications of waveguides created in silicon using an SOI substrate with a silicon dioxide cap layer. This material system is merely described by way of example and embodiments of the present invention can be implemented in other material systems.

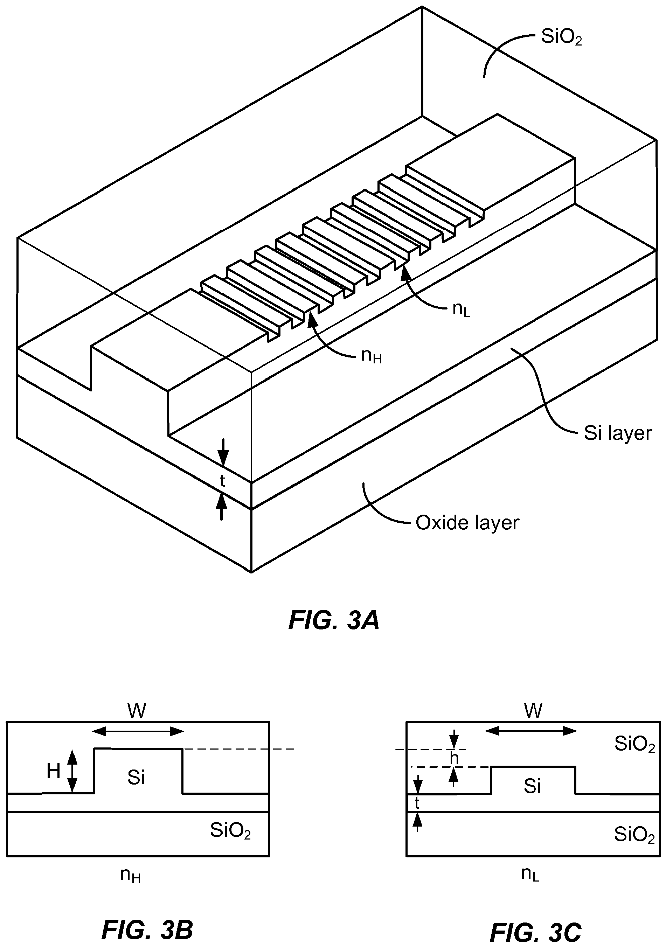

FIG. 3A is a simplified perspective view of a waveguide according to an embodiment of the present invention. As illustrated in FIG. 3A, a waveguide structure is formed with a periodic variation in thickness of one or more layers making up the waveguide. In the illustrated embodiment, the SOI silicon layer varies in thickness with a high portion having thickness H and a low portion having thickness H-h. The width of the waveguide is W. For purposes of clarity, only the top two SOI layers (i.e., the SOI oxide layer and the SOI silicon layer) are illustrated in FIGS. 3A-3C. FIG. 3B is a simplified cross-sectional view at a high index portion of the waveguide illustrated in FIG. 3A according to an embodiment of the present invention. FIG. 3C is a simplified cross-sectional view at a low index portion of the waveguide illustrated in FIG. 3A according to an embodiment of the present invention. It should be noted that the top $SiO_2$ layer shown in these figures may be replaced by another index-controlled layer such as air, $TiO_2$, SiC, ZnS, $Nb_2O_5$, $HfO_2$, $ZrO_2$. As will be evident to one of skill in the art, the indexes of the various materials will impact the shape of the optical modes.

The waveguide structure was analyzed to determine an effective index for the various sections of the waveguide. A vector EM mode solver was used and applied to two different single mode ridge waveguides with two different ridge heights. The effective indices $n_H$ and $n_L$ and mode profiles could be extracted, then the full three-dimensional problem was a one-dimensional problem, with the one-dimensional transfer matrix method efficiently simulating the multi-layer structures. The index difference created reflections that accumulated coherently over the length result in differing reflectances versus wavelength.

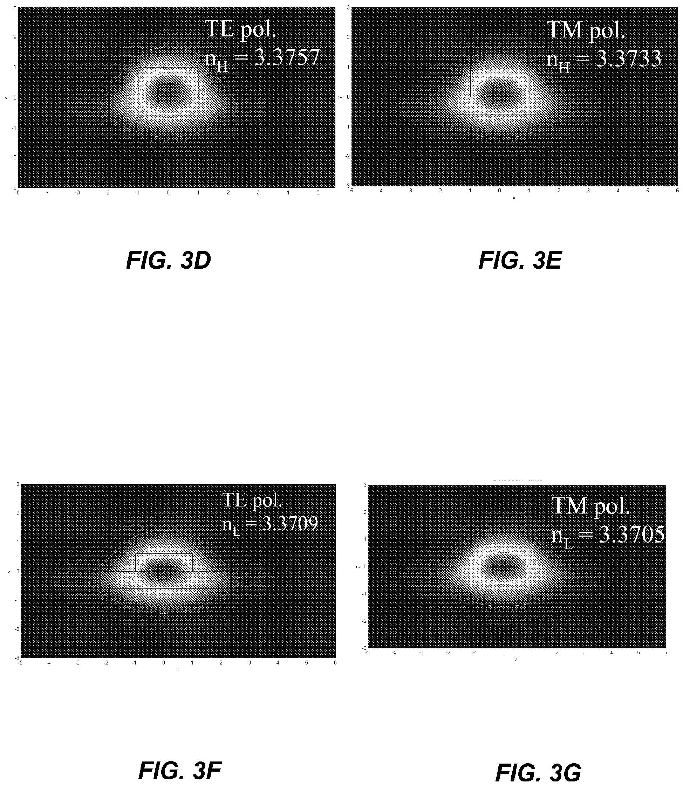

FIG. 3D is a contour plot illustrating a TE mode for the high index portion of the waveguide illustrated in FIG. 3B. FIG. 3E is a contour plot illustrating a TM mode for the high index portion of the waveguide illustrated in FIG. 3B. FIG. 3F is a contour plot illustrating a TE mode for the low index portion of the waveguide illustrated in FIG. 3C. FIG. 3G is a contour plot illustrating a TM mode for the low index portion of the waveguide illustrated in FIG. 3C.

FIG. 4A illustrates a reflectance spectrum for a first modulated grating reflector according to an embodiment of the present invention and FIG. 4B illustrates a reflectance spectrum for a second modulated grating reflector according to an embodiment of the present invention. As illustrated in FIG. 4A, the grating structure includes a superstructure grating (SSG) in which periodically modulated gratings provide a comb-like reflection spectrum. In these gratings, multiple elements of periodicity are provided such that the mode spacing associated with the grating is overlaid with an envelope. The spacing between the modes of the comb will be a function of the height and other features of the grating features formed in the waveguide.

As an example of an SSG, the reflectance spectrum illustrated in FIG. 4A was obtained using the following 3-step modulated superstructure grating parameters:

Duty cycles = [0.5 0.5 0.5]

Periods = [227.7 230 232.3] nm

$N_{sub}$ = [110 109 108]

$$\Lambda_S = (25.047 + 25.07 + 25.088) = 75.205 \text{ } \mu m$$

$n_H = 3.3757; n_L = 3.3709;$

$$\Delta n = n_H - n_L = 0.0048$$

$N_p = 11$

Total number of periods = 3597 mixed periods

For these grating parameters, a mode spacing of $\Delta\lambda_1 = 4.7$ nm was achieved.

As another example of a SSG, the reflectance spectrum illustrated in FIG. 4B was obtained using the following 3-step modulated superstructure grating parameters:

Duty cycles = [0.5 0.5 0.5]

Periods = [228.2 230 231.8] nm

$N_{sub}$ = [131 130 129]

$$\Lambda s = (29.894 + 29.9 + 29.902) = 89.696 \text{ } \mu m$$

$n_H = 3.3757; n_L = 3.3709;$

$$\Delta n = n_H - n_L = 0.0048$$

$N_p = 11$

Total number of periods = 4290 mixed periods

For these grating parameters, a mode spacing of $\Delta\lambda_2 = 4.0$ nm was achieved.

FIG. 4C illustrates an overlay of the reflectance spectra shown in FIG. 4A and FIG. 4B. FIG. 4D illustrates constructive interference between the reflectance spectra shown in FIG. 4A and FIG. 4B. The first and second modulated grating reflectors are designed to provide different peak spacings such that only a single peak is aligned. Thus, only one cavity mode is selected for lasing. As described below, the single peak can be widely tuned over wavelength space based on thermal effect, free carrier injection, or the like. Although embodiments of the present invention are illustrated in relation to operation and tunability around 1550 nm, other wavelengths are available using appropriate semiconductor laser materials.

Thus, implementations of the silicon hybrid tunable laser of the present invention was capable of tuning over the substantially entire wavelength range of interest. Tuning can be achieved, as described more fully below using several techniques including thermal tuning. Referring once again to FIGS. 4A and 4B, the illustrated embodiment is operable over a range of temperatures including 40°C. Tuning of the laser wavelength can be considered as follows: the comb of wavelengths illustrated in FIG. 4A is created by the first modulated grating reflector 12 illustrated in FIG. 1A. The comb of wavelengths illustrated in FIG. 4B is created by the second modulated grating reflector 14 illustrated in FIG. 4B. The overlay of the first comb and the second comb is illustrated in FIG. 4C and demonstrates the combination of the wavelengths obtained from the first modulated grating reflector 12 and the second modulated grating reflector 14. The constructive interference between the two wavelength combs is illustrated in FIG. 4D, with substantially a single peak in the reflectance profile. The one strong reflection peak thus produces the single laser mode, which is the only mode supported by the combined reflectances. In an embodiment, the spectrum illustrated in FIG. 4D will be present as the output of the optical coupler 16 provided to the phase adjustment section 18.

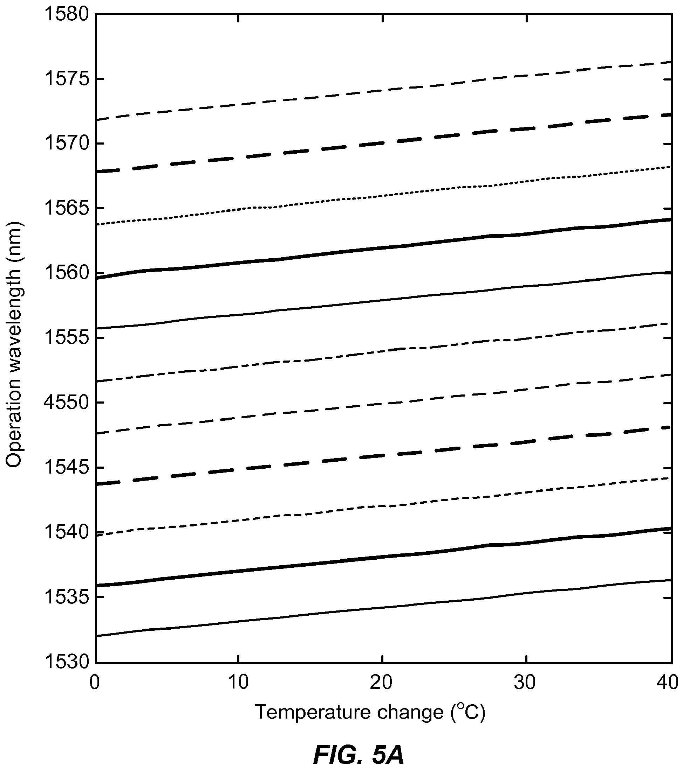

FIG. 5A is a plot illustrating operating wavelength as a function of temperature change according to an embodiment of the present invention. As illustrated in FIG. 5A, the operating wavelength shifts as a function of temperature in a substantially linear manner. As will be evident to one of skill in the art, the shift in wavelength of the reflection peak as a function of temperature (and index of refraction) results in the shift in operating wavelength.

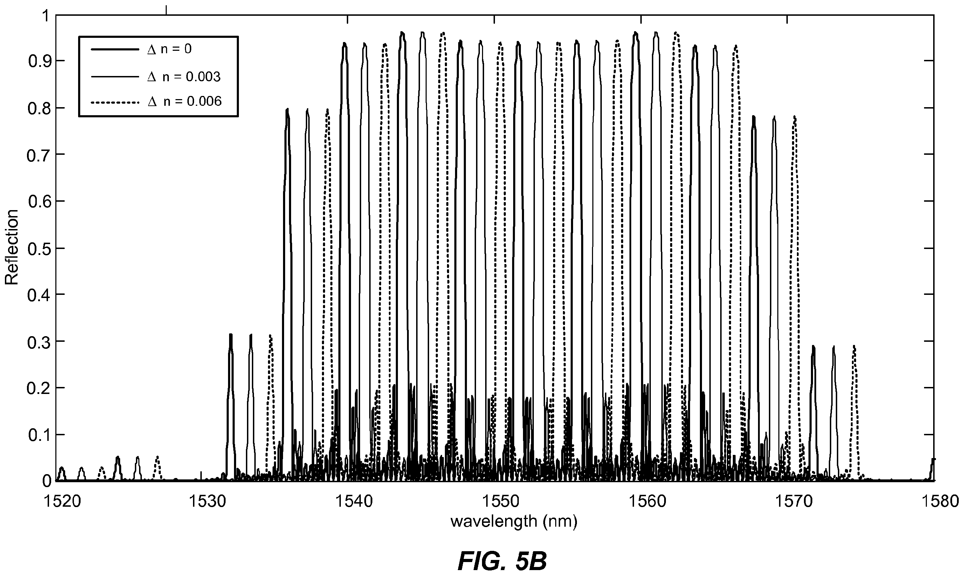

FIG. 5B illustrates wavelength shifting of a reflectance spectrum as a function of index of refraction according to an embodiment of the present invention. For a nominal index ($\Delta n=0$), the peaks of the comb are located at a first set of wavelengths. As the index of refraction is shifted, for example, by thermal tuning, the comb shifts to a new set of wavelengths as illustrated by the combs associated with $\Delta n=0.003$ and $\Delta n=0.006$. Thus, embodiments of the present invention provide for tunability of silicon photonics in which tuning is accomplished using the thermo optic (TO) effect of silicon. The TO coefficient of silicon is approximately

$$C_{TO} = 2.4 \times 10^4 K^{-1}$$

over the temperature range up to 650°C. In the embodiments described herein, a conventional silicon ridge waveguide was used for waveguiding so that the TO is considered to be in the same range as the value given above. The index of refraction due to the TO effect can be expressed as:

$$\Delta n = C_{TO}\Delta T .$$

Thus, for a temperate change of about 40°C, a change in the index of refraction of about 0.0096 can be provided for silicon material. As illustrated in FIG. 5B, this translates to a change of about 4 nm in laser wavelength change. It should be noted that the dynamic tuning range for each mode can be adjusted by increasing the number of super-periods ($N_p$).

In addition to thermal tuning, embodiments of the present invention can utilize current tuning based on the Kramer-Kronig relation.

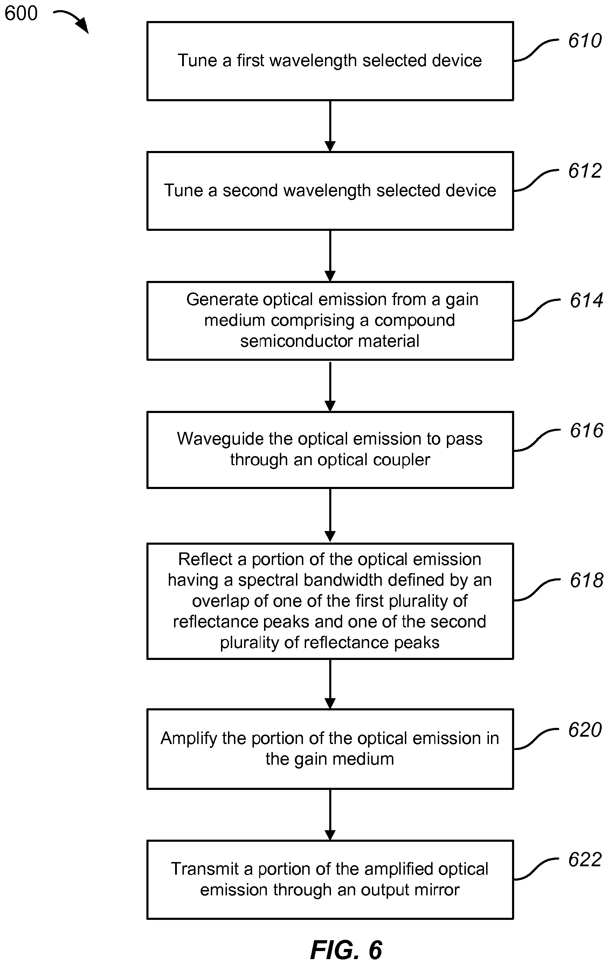

FIG. 6 is a simplified flowchart illustrating a method of operating a hybrid integrated laser according to an embodiment of the present invention. The method 600, which may be utilized in operating a tunable laser, includes tuning a first wavelength selective device (e.g., a first modulated grating reflector disposed in a silicon layer of an SOI wafer) (610) and tuning a second wavelength selective device (e.g., a second modulated grating reflector disposed in the silicon layer of the SOI wafer) (612). The first wavelength selective device is characterized by a first reflectance spectra including a first plurality of reflectance peaks. The second wavelength selective device is characterized by a second reflectance spectra including a second plurality of reflectance peaks. In a particular embodiment, a first modulated grating reflector includes a superstructure grating characterized by a first wavelength spacing between modes and a second modulated grating reflector includes a superstructure grating characterized by a second wavelength spacing between modes that is different than the first wavelength spacing between modes. The wavelength selective devices can include index of refraction adjustment devices such as thermal devices that enable the tuning functionality that is provided. In applications with thermal devices, temperature sensors such as RTDs can be used to monitor and control thermal inputs. One of ordinary skill in the art would recognize many variations, modifications, and alternatives.

The method also includes generating optical emission from a gain medium comprising a compound semiconductor material (614) and waveguiding the optical emission to pass through an optical coupler (616). The optical emission may pass through a phase adjustment region. The method further includes reflecting a portion of the optical emission having a spectral bandwidth defined by an overlap of one of the first plurality of reflectance peaks and one of the second plurality of reflectance peaks (618), amplifying the portion of the optical emission in the gain medium (620), and transmitting a portion of the amplified optical emission through an output mirror (622).

It should be appreciated that the specific steps illustrated in FIG. 6 provide a particular method of operating a hybrid integrated laser according to an embodiment of the present invention. Other sequences of steps may also be performed according to alternative embodiments of the present invention may perform the steps outlined above in a different order. Moreover, the individual steps illustrated in FIG. 6 may include multiple sub-steps that may be performed in various sequences as appropriate to the individual step. Furthermore, additional steps may be added or removed depending on the particular applications. One of ordinary skill in the art would recognize many variations, modifications, and alternatives.

Embodiments of the present invention relate to an apparatus and method that preferably uses a bonding stress for wafer bonding and utilizes an intermediate layer to facilitate the transition from silicon and the like to another material for optical coupling as well as electron transport. Embodiments of the present invention preferably incorporate low stress, low temperature wafer bonding known in the industry and preferably comprise a thin film intermediate layer for optical coupling as well electron transport.

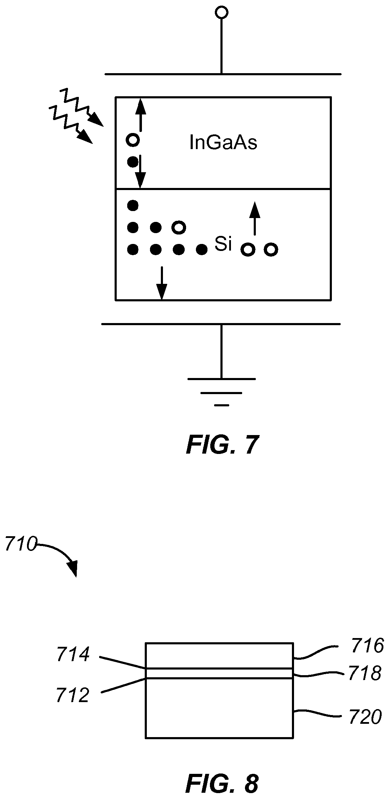

FIG. 7 illustrates an example of a photodiode with a low stress bond between a III-V substrate and a silicon substrate. FIG. 8 illustrates a bonded structure according to an embodiment of the present invention. As illustrated in FIG. 8, two interfaces 712 and 714 are provided. First interface 712 is positioned between a silicon substrate 720 and an intermediate layer 718. Second interface 714 is located between intermediate layer 718 and a second semiconductor layer 716. Embodiments of the present invention are preferably used in the bonding process to facilitate integration of heterogeneous materials. Embodiments that facilitate integration preferably share the stress due to lattice mismatch between the silicon crystal and the second semiconductor that can form at these two interfaces and can be greatly reduced because of the reduced need for crystalline in the intermediate layer. The intermediate layer can be an alloy whose composition can be graded across the layer to facilitate the bonding at both interfaces 712 and 714.

Intermediate layer 718 is preferably thin, ranging from between approximately 4-5 monolayers to more than approximately 60-70 monolayers, substantially allowing the optical and thermal conduction properties to be virtually unaffected while the electron transport can preferably be achieved via actual carrier transport across the layer. In some embodiments of the present invention, intermediate layer 718 forms thermal and electric contacts at both the first interface and second interface. Embodiments of the present invention can be used in the fabrication of a plurality of high performance optoelectronic components, including but not limited to modulators, lasers, detectors, amplifiers, couplers, wavelength tunable optical components and/or circuits, combinations thereof, or the like. Embodiments as described herein are applicable to a variety of material systems including silicon as illustrated by silicon substrate 720 and/or the like and second semiconductor materials 716, which can be a compound semiconductor material. Utilizing embodiments of the present invention, heterogeneous materials (e.g., compound semiconductors and silicon substrates can be integrated on a common substrate.

The term "bandgap" as used throughout this application includes but is not limited to the energy difference between the top of the valence band and the bottom of the conduction band. The term "optical coupling" as used throughout this application includes but is not limited to placing two or more electromagnetic elements including optical waveguides close together so that the evanescent field generated by one element does not decay much before it reaches the other element. The term "electron transport" as used throughout this application includes but is not limited to an electron transport chain coupling a chemical reaction between an electron donor and an electron acceptor to the transfer of $H^+$ ions across a membrane, through a set of mediating chemical or biochemical reactions. The term "complementary metal oxide semiconductor" as used throughout this application includes but is not limited to technologies for making integrated circuits, microprocessors, microcontrollers, static RAM, digital logic circuits, analog circuits, and highly integrated transceivers.

Embodiments of the present invention optionally utilize several features of intermediate layer 718 as illustrated in FIG. 8. According to an embodiment, the thickness of the intermediate layer 718 is very thin, ranging from a few monolayers (i.e., around 10 Å in thickness) to tens of monolayers. In an embodiment, the intermediate layer is deposited using a deposition technique that provides for uniform coverage at small thicknesses. Exemplary deposition techniques include PVD, ALD, sputtering, e-beam deposition, or the like. Intermediate layer 718 is preferably deposited at relatively low temperatures ranging from temperatures less than 200 °C. At these low temperatures, there preferably exist small differences of thermal expansion (i.e., differences in the coefficient of thermal expansion (CTE)) between first interface 712 and second interface 714. Intermediate layer 718 preferably forms thermal contacts at the interfaces and is preferably thermally conductive. Intermediate layer 718 preferably forms good electrical contacts at both interfaces and is preferably electrically conductive. It is not necessary to be crystalline in nature so that the lattice matching at both interfaces is not an issue. In some embodiments, intermediate layer 718 is an alloy material for which the composition varies across the layer.

Embodiments of the present invention are applicable to an apparatus that includes a semiconductor layer that is provided over an intermediate layer that is provided over a silicon substrate layer. The intermediate layer has a lower thermal conductivity than the semiconductor layer. The apparatus also includes a plurality of interfaces that are provided between the semiconductor layer and the underlying layer(s), thereby preventing crystalline lattice mismatch.

Embodiments of the present invention also include a bonding method including forming first and second bonding surfaces on first and second materials, respectively, at least one of the bonding surfaces including an intermediate layer. The method also includes enhancing activation of at least one of said first and second bonding surfaces, terminating at least one of said first and second bonding surfaces with species allowing formation of chemical and electrical bonds, and annealing said first and second materials at a temperature.

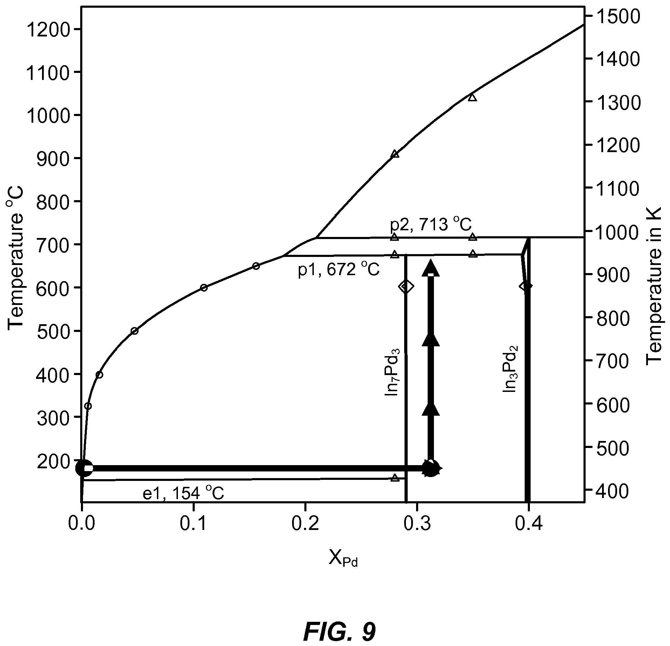

FIG. 9 illustrates a phase diagram showing alloy stability according to an embodiment of the present invention. As illustrated in FIG. 9, the stability of the alloy makes such an alloy suitable for use as an intermediate layer such as intermediate layer 718. In some embodiments, the alloy (e.g., $In_xPd_y$) has a small thickness to accommodate stress at the semiconductor-semiconductor interface.

While the embodiments of the invention described herein are directed to wafers used in the semiconductor industry, the invention is also applicable to thermoelectric (TE) cooling technology as well as virtually any application including optical coupling and electron transport.

Merely by way of example, an intermediate layer suitable for use according to embodiments of the present invention is $In_xPd_y$, for example, $In_{0.7}Pd_{0.3}$, which is an alloy that is stable up to very high temperatures as illustrated in FIG. 9. This alloy forms an ohmic contact at interfaces with both silicon and/or III-V materials for which the doping types at either side can be either p-type or n-type. Thus, embodiments of the present invention provide an intermediate layer that provides both ohmic contact between materials on both sides of the intermediate layer, adhesion, optical quality including transparency (i.e., low optical loss), stress accommodation, and other benefits. Other suitable alloys include germanium palladium, gold/germanium, Au/Sn, Al/Mg, Au/Si, palladium, indium/tin/silver alloys, metal alloys containing Bi, Sn, Zn, Pb, or In, combinations thereof, or the like. The optimal alloy will generally have eutectic or peritectic points, and will allow a bonding process temperature in the 350 °C to 500 °C range.

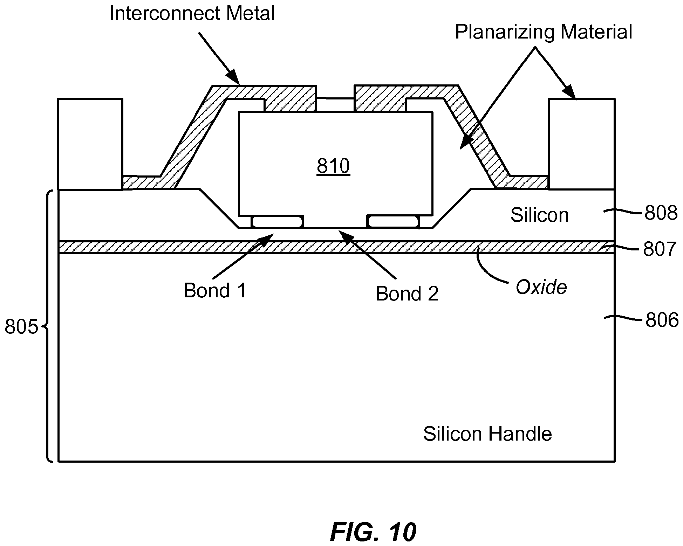

FIG. 10 is a simplified schematic diagram of a compound semiconductor structure bonded to a silicon substrate according to an embodiment of the present invention. Referring to FIG. 10, a composite metal/semiconductor bond is illustrated in relation to bonding of a compound semiconductor device 810 to a silicon-based substrate 805. In the embodiment illustrated in FIG. 10, the silicon-based substrate 805 is a silicon-on-insulator (SOI) substrate although this is not required by embodiments of the present invention. The SOI substrate includes a silicon handle layer 806, a silicon oxide layer 807, and a silicon layer 808, which may be single crystal silicon. Planarizing material is used in the embodiment illustrated in FIG. 10 as well as an interconnect metal that provides for electrical conductivity between portions of the compound semiconductor device 810 and the silicon layer 808 of the SOI substrate. In the embodiment illustrated in FIG. 10, the compound semiconductor device 810 extends to a height above the top surface of the silicon layer 808.

As illustrated in FIG. 10, several bonds are formed between silicon layer 808 and the compound semiconductor device 810. Bond 1 is a metal/metal bond. Associated with Bond 1, pads (not shown in FIG. 10 but illustrated in following figures) are defined on both the SOI substrate (e.g., silicon layer 808) and the compound semiconductor device 810. These pads can include an adhesion metal such as Ti or Cr and a barrier metal such as Pt or Ni. The metal used for the bonding process will typically be a eutectic solder with a eutectic point in the 350°C - 500°C range. An example of such a eutectic solder is AuGe.

Bond 2 as illustrated in FIG. 10 can be either a direct semiconductor/semiconductor bond or a metal-assisted semiconductor/semiconductor bond. For the metal-assisted semiconductor/semiconductor bond, a thin metal layer (e.g., ranging from one to a few monolayers to a few tens of monolayers) is deposited to improve the robustness of the interface and to better accommodate the CTE differences between silicon and the compound semiconductor device. In an embodiment, the thin metal layer is less than 50 Å in thickness. The very thin interfacial metal will still allow light to pass through without significant attenuation. The direct semiconductor/semiconductor bond can be formed using techniques including either chemical activation or plasma activation of the surfaces and joining the materials together with pressure and low temperature in order to bond the two surfaces together. Direct semiconductor bonding is useful in devices employing evanescent coupling in a waveguide structure as it will have lower optical attenuation than metal-assisted semiconductor bonding.

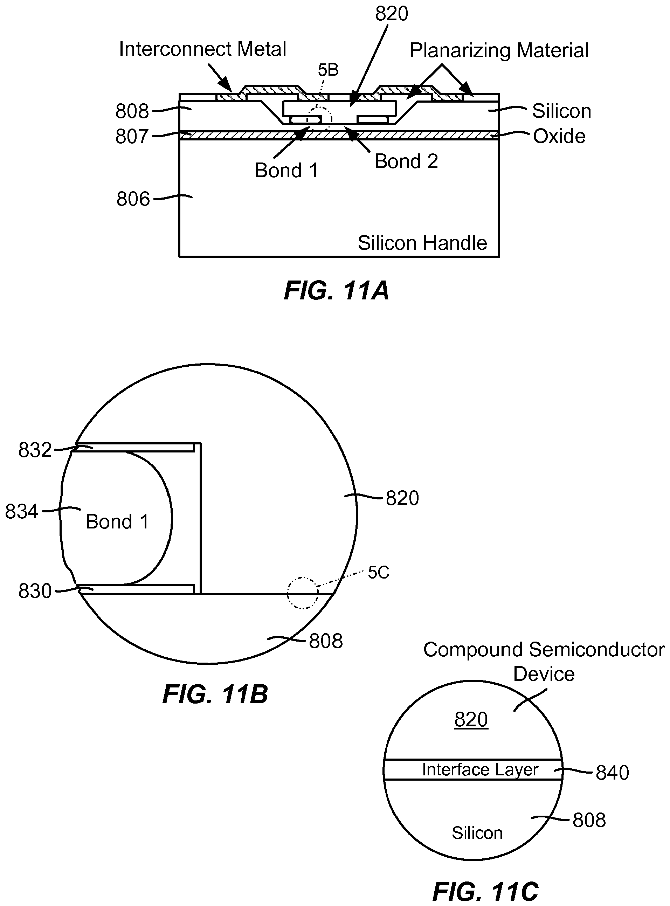

FIGS. 11A-11C are simplified schematic diagrams illustrating bond interfaces according to an embodiment of the present invention. As illustrated in FIG. 11A, the compound semiconductor device 820 has been thinned so that the top surface of the compound semiconductor device 820 is coplanar with the top surface of silicon layer 808. A planarizing material has been used to provide a planar surface extending above the top surface of silicon layer 808. Portions of the planarizing material have been removed (e.g., using a masking and etching process) and interconnect metals have been used to provide for electrical connectivity between portions of the silicon layer 808 and portions of the compound semiconductor device 820.

FIG. 11B illustrates additional details related to Bond 1 including pads 830 and 832 that provide for adhesion between the silicon layer 808, the bonding metal 834 and the compound semiconductor device 820. As discussed in relation to FIG. 10, pads 830 and 832 can include an adhesion metal such as Ti or Cr and a barrier metal such as Pt. The bonding metal 834 can be a eutectic solder such as AuGe. Other pad materials include Ni, W, refractory metals used as barrier layers in silicon-based devices, or the like, and other bonding metals include AuSn, InPd, InSn, InSnAg alloys, combinations thereof, or the like. These materials are listed merely by way of example and other materials that provide for adhesion between surfaces and/or barrier functionality are also included within the scope of the present invention.

FIG. 11C illustrates the use of an interface layer 840 between the compound semiconductor device 820 and the silicon layer 808. As discussed previously, the metal-assisted semiconductor/semiconductor bond illustrated in FIG. 11C includes a thin metal layer that provides beneficial functions including improving the robustness of the interface and accommodating CTE differences between the materials bonded to either side of this interface layer. Interface layers can include suitable materials including materials that provide peritectic properties including metals such as InPd, other metal alloys, combinations thereof, or the like. Gettering materials such as Ti or Cr can also be integrated with the interface layer to getter surface oxides and improve bond properties. For thin layers of interfacial metals, light will be able to pass without significant attenuation. The low optical loss provided by embodiments of the present invention include absorption coefficients that can be computed using waveguide models and the measured absorption properties of the interface layer. The use of an interface layer 840 will also provide an ohmic contact between the silicon layer 808 and the compound semiconductor device 820. Thus, embodiments of the present invention provide an interface that is electrically conductive without significant optical absorption.

Although FIGS. 11A-11C illustrate bonding of a compound semiconductor device to an SOI substrate, embodiments of the present invention are not limited to the bonding of a device to a substrate. Other embodiments of the present invention are applicable to substrate to substrate bonding, also referred to as wafer bonding. Thus, the compound semiconductor device illustrated in the figures can be replaced with a compound semiconductor substrate in the processes and structures described herein. One of ordinary skill in the art would recognize many variations, modifications, and alternatives.

As illustrated in FIG. 11C, an interface layer 840 such as a thin layer (e.g., less than 100 Å) of a metal alloy such as $In_xPd_y$, can be used to accommodate some of the CTE mismatch between the two semiconductor materials. In other embodiments, the interface layer is not present and a direct semiconductor/semiconductor bond is formed for Bond 2. Embodiments of the present invention utilize both a metal/metal bond illustrated by Bond 1 and a direct semiconductor/semiconductor bond or an interface assisted semiconductor/semiconductor bond illustrated by Bond 2. Such a hybrid bonding approach utilizes the benefits provided by both types of bonds to reduce or overcome the disadvantages of low temperature semiconductor/semiconductor bonding including the weak interface as well as the disadvantages of metal/metal bonding including high optical loss in the vicinity of the metal/metal bond. Thus, embodiments of the present invention provide for high strength bonds and electrical conductivity (Bond 1) while enabling low optical loss and electrical conductivity in regions of the structure suitable for light propagation (Bond 2).

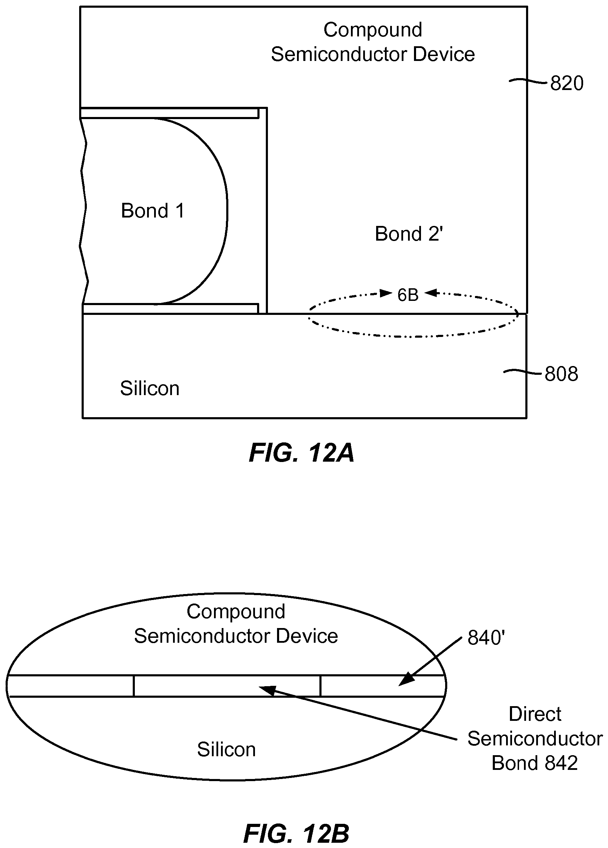

FIGS. 12A-12B are simplified schematic diagrams illustrating bond interfaces according to another embodiment of the present invention. In the case where light propagates parallel to the interface formed at Bond 2 and evanescent coupling is used between the silicon layer 808 and the compound semiconductor device 820, a combination of direct semiconductor-semiconductor bonding and metal-assisted semiconductor-semiconductor bonding may be employed to form Bond 2. This can be achieved by selective patterning of the thin interfacial metal. Referring to FIG. 12A, Bond 2' between the silicon layer 808 and the compound semiconductor device 810 is illustrated. Bond 2' includes not only an interface layer 840' similar to layer 840 in FIG. 11C, but a direct semiconductor-semiconductor bond 842. In the embodiment illustrated in FIG. 12B, the interface layer 840' is patterned to provide regions that are free of the interface layer, which may be a metal layer. As an example, in a light emitting device, the direct semiconductor-semiconductor bond could be positioned adjacent the light emission region to prevent absorption of light by the interface layer. The combination of an interface layer with a direct semiconductor-semiconductor bond thus provides benefits associated with each of the bonding techniques in a hybrid manner.

The bonding processes described herein can be performed in the temperature range from about 350°C to about 500°C. In a particular embodiment, the temperature associated with the bonding process is in the temperature range of 400°C - 450°C. These temperatures are below the temperature at which CMOS circuits, which may be previously fabricated on the SOI substrate, would be damaged. This enables the integration of complex electrical functions while still providing a robust bond between the dissimilar materials discussed herein.

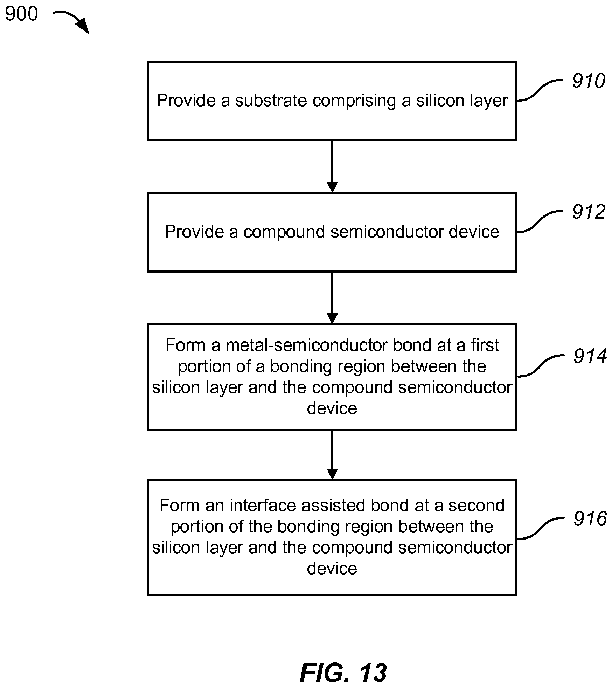

FIG. 13 is a simplified flowchart illustrating a method of fabricating a hybrid semiconductor structure according to an embodiment of the present invention. The method 900 includes providing a substrate comprising a silicon layer (910), providing a compound semiconductor device (e.g., an InP semiconductor laser) (912), and forming a bonding region disposed between the silicon layer and the compound semiconductor device. Forming the bonding region includes forming a metal-semiconductor bond at a first portion of the bonding region (914). The metal-semiconductor bond includes a first pad bonded to the silicon layer, a bonding metal bonded to the first pad, and a second pad bonded to the bonding metal and the compound semiconductor device. Forming the bonding region also includes forming an interface assisted bond at a second portion of the bonding region (916). The interface assisted bond includes an interface layer (e.g., $In_xPd_y$) positioned between the silicon layer and the compound semiconductor device. The interface assisted bond provides an ohmic contact between the silicon layer and the compound semiconductor device. In an embodiment, the interface layer has a thickness less than 50 Å.

According to an embodiment, the substrate includes an SOI wafer including a silicon substrate, an oxide layer disposed on the silicon substrate, and the silicon layer is disposed on the oxide layer. In embodiments utilizing a laser or other light generator, the second portion of the bonding region can be substantially free from the interface layer at a position adjacent an active region of the laser or optical generator in order to reduce optical losses. The bonding processes can be performed using low temperature bonding processes, for example, at a temperature ranging from about 350°C to about 500°C, more particularly, from about 400°C to about 450°C.

It should be appreciated that the specific steps illustrated in FIG. 13 provide a particular method of fabricating a hybrid semiconductor structure according to an embodiment of the present invention. Other sequences of steps may also be performed according to alternative embodiments. For example, alternative embodiments of the present invention may perform the steps outlined above in a different order. Moreover, the individual steps illustrated in FIG. 13 may include multiple sub-steps that may be performed in various sequences as appropriate to the individual step. Furthermore, additional steps may be added or removed depending on the particular applications. One of ordinary skill in the art would recognize many variations, modifications, and alternatives.

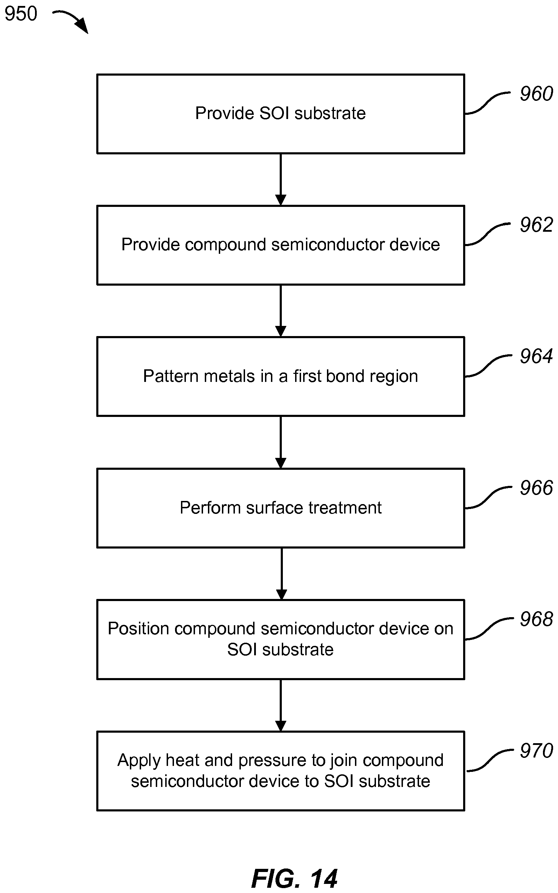

FIG. 14 is a simplified flowchart illustrating a method of fabricating a hybrid semiconductor structure according to another embodiment of the present invention. The method 950 includes providing an SOI substrate (960) and providing a compound semiconductor device (962), which can also be referred to as a compound semiconductor die. In an embodiment of the present invention, the SOI substrate includes one or more optical components such as waveguides, optical isolators, reflective structures, or the like and the compound semiconductor device is an InP gain medium.

The method also includes patterning metals in a first bond region (964). The metals can be deposited or formed in a variety of manners. The first bond region can be used for metal-metal bonding and/or for metal-assisted semiconductor-semiconductor bond on one or both materials. After the metals are patterned, a surface treatment is performed (966), for example, a chemical treatment of the surface(s), a plasma activation for a semiconductor-semiconductor bond without metal assist, or the like. The surface treatment can be performed in a controlled atmosphere such as an inert environment, a reduced pressure atmosphere such as a vacuum, or the like. The method further includes positioning the compound semiconductor device on the SOI substrate, such as a receptor site (968) and applying heat and pressure to join the compound semiconductor device to the SOI substrate (970). In an embodiment, the joining step simultaneously effects both metal-based and semiconductor-based bonds.

It should be appreciated that the specific steps illustrated in FIG. 14 provide a particular method of fabricating a hybrid semiconductor structure according to another embodiment of the present invention. Other sequences of steps may also be performed according to alternative embodiments. For example, alternative embodiments of the present invention may perform the steps outlined above in a different order. Moreover, the individual steps illustrated in FIG. 14 may include multiple substeps that may be performed in various sequences as appropriate to the individual step. Furthermore, additional steps may be added or removed depending on the particular applications. One of ordinary skill in the art would recognize many variations, modifications, and alternatives.

**Claims**

1.  A tunable laser (10) comprising:

    a substrate (22) comprising a silicon material;
    a gain medium (20) coupled to the substrate, wherein the gain medium is in a recessed region of the silicon material, and the gain medium includes a compound semiconductor material;
    a waveguide disposed in the substrate (22) and optically coupled to the gain medium (20);
    a first wavelength selective element (12) **characterized by** a first reflectance spectrum and disposed in the substrate (22);
    a second wavelength selective element (14) **characterized by** a second reflectance spectrum and disposed in the substrate (22); and
    an optical coupler disposed in the substrate (22) and joining the waveguide, the first wavelength selective element (12) and the second wavelength selective element (14);
    an index matching region (18) filled with index matching material between the gain medium (20) and the waveguide; and
    an output mirror.

2.  The tunable laser of claim 1 wherein:

    the first wavelength selective element (12) comprises a first modulated grating reflector; and
    the second wavelength selective element (14) comprises a second modulated grating reflector.

3.  The tunable laser of claim 2 wherein the first modulated grating reflector (12) comprises a superstructure grating **characterized by** a first wavelength spacing between modes.

4.  The tunable laser of claim 3 wherein the second modulated grating reflector (14) comprises a superstructure grating **characterized by** a second wavelength spacing between modes different than the first wavelength spacing between modes.

5.  The tunable laser of claim 1 wherein:

    the first wavelength selective element (12) comprises a first index of refraction adjustment device; and
    the second wavelength selective element (14) comprises a second index of refraction adjustment device.

6.  The tunable laser of claim 5,
    wherein the first index of refraction adjustment device comprises a thermal device (26); and the second index of refraction adjustment device comprises a thermal device (27); and/or
    wherein the first wavelength selective element further comprises a first temperature sensor (28); and the second wavelength selective element further comprises a second temperature sensor (29).

7.  The tunable laser of claim 1,
    wherein the tunable laser (10) further comprises a phase adjustment section optically coupled between the waveguide and the optical coupler; and/or wherein the tunable laser further comprises a second phase adjustment section operable to modify an optical phase in at least one of the first wavelength selective element (12) or the second wavelength selective element (14).

8.  The tunable laser of claim 1 wherein:

    the silicon material comprises a silicon on insulator wafer having a silicon substrate, an oxide layer disposed on the silicon substrate, and a silicon layer disposed on the oxide layer;
    the silicon layer is single crystal silicon; and
    the waveguide is in the silicon layer.

9.  The tunable laser of claim 8 wherein the first wavelength selective element (12) and the second wavelength selective element (14) are disposed in the silicon layer.

10.  The tunable laser of claim 1 further comprising a semiconductor/ semiconductor interface between the gain medium (20) and the substrate (22).

11.  A method of operating a tunable laser (10), the method comprising:

    tuning a first modulated grating reflector (12), wherein the first modulated grating reflector is **characterized by** a first reflectance spectra including a first plurality of reflectance peaks;
    tuning a second modulated grating reflector (14), wherein the second modulated grating reflector is **characterized by** a second reflectance spectra including a second plurality of reflectance peaks;

generating optical emission from a gain medium (20), wherein:

the gain medium is coupled to a substrate (22) having silicon material;

the gain medium is in a recessed region of the silicon material; and

the gain medium comprises a compound semiconductor material;

optically coupling light from the gain medium to a waveguide using an index matching region filled with index matching material, wherein the waveguide is disposed in the substrate;

waveguiding the optical emission to pass through an optical coupler;

reflecting a portion of the optical emission having a spectral bandwidth defined by an overlap of one of the first plurality of reflectance peaks and one of the second plurality of reflectance peaks;

amplifying the portion of the optical emission in the gain medium (20); and

transmitting a portion of the amplified optical emission through an output mirror.

**12.** The method of claim 11 wherein the first modulated grating reflector (12) comprises a superstructure grating **characterized by** a first wavelength spacing between modes.

**13.** The method of claim 12 wherein the second modulated grating reflector (14) comprises a superstructure grating **characterized by** a second wavelength spacing between modes different than the first wavelength spacing between modes.

**14.** The method of claim 11 wherein:

the first modulated grating reflector (12) comprises a first index of refraction adjustment device; and

the second modulated grating reflector (14) comprises a second index of refraction adjustment device.

**15.** The method of claim 11 further comprising phase adjusting the optical emission.


**Patentansprüche**

**1.** Abstimmbarer Laser (10), enthaltend:

ein Siliziummaterial beinhaltendes Substrat (22);

ein an das Substrat gebundenes Verstärkungsmedium (10), wobei sich das Verstärkungsmedium in einem vertieften Bereich des Siliziummaterials befindet und das Verstärkungsmedium eine Verbindungs-Halbleiter-Material enthält;

einen in dem Substrat (22) angeordneten und optisch an das Verstärkungsmedium (20) gekoppelten Wellenleiter;

ein erstes Wellenlängen-selektives Element (12), **gekennzeichnet durch** ein erstes Reflexionsspektrum und in dem Substrat (22) angeordnet;

ein zweites Wellenlängen-selektives Element (14), **gekennzeichnet durch** ein zweites Reflexionsspektrum und in dem Substrat (22) angeordnet; und

eine in dem Substrat (22) angeordnete optische Kopplung, die den Wellenleiter, das erste Wellenlängen-selektive Element (12) und das zweite Wellenlängen-selektive Element (14) verbindet;

einen Brechungsindex-angepasster Bereich (18), der mit Brechungsindexangepasstem Material zwischen dem Verstärkungsmedium (20) und dem Wellenleiter gefüllt ist; und

einen Ausgangsspiegel.

**2.** Abstimmbarer Laser nach Anspruch 1, wobei:

das erste Wellenlängen-selektive Element (12) einen ersten modulierten Gitter-Reflektor enthält; und

das zweite Wellenlängen-selektive Element (12) einen zweiten modulierten Gitter-Reflektor enthält.

**3.** Abstimmbarer Laser nach Anspruch 2, wobei:
der erste modulierte Gitter-Reflektor (12) ein Superstruktur-Gitter, **gekennzeichnet durch** einen ersten Wellenlängenabstand zwischen Moden, enthält.

**4.** Abstimmbarer Laser nach Anspruch 3, wobei:

der zweite modulierte Gitter-Reflektor (12) ein Superstruktur-Gitter, **gekennzeichnet durch** einen zweiten Wellenlängenabstand zwischen Moden, welche anders ist als der erste Wellenlängenabstand zwischen Moden, enthält.

**5.** Abstimmbarer Laser nach Anspruch 1, wobei:

das erste Wellenlängen-selektive Element (12) ein erstes Brechungsindex-Einstellungsgerät enthält; und
das zweite Wellenlängen-selektive Element (14) ein zweites Brechungsindex-Einstellungsgerät enthält.

6. Abstimmbarer Laser nach Anspruch 5,
wobei das erste Brechungsindex-Einstellungsgerät ein thermisches Gerät (26) enthält; und das zweite Brechungsindex-Einstellungsgerät ein thermisches Gerät (27) enthält; und/oder
das erste Wellenlängen-selektive Element (12) ferner einen ersten Temperatursensor (28) enthält; und das zweite Wellenlängen-selektive Element (14) ferner einen zweiten Temperatursensor (29) enthält.

7. Abstimmbarer Laser nach Anspruch 1,
wobei der abstimmbare Laser (10) ferner einen Phaseneinstellungs-Abschnitt, der optisch zwischen dem Wellenleiter und der optischen Kopplung gekoppelt ist, enthält; und/oder
wobei der abstimmbare Laser (10) ferner einen zweiten Phaseneinstellungs-Abschnitt, der operabel zur Modifikation einer optischen Phase in mindestens einem des ersten Wellenlängen-selektiven Elements und des zweiten Wellenlängen-selektiven Elements ist, enthält.

8. Abstimmbarer Laser nach Anspruch 1,
wobei das Siliziummaterial einen Silizium-auf-Isolator-Wafer enthält, der ein Siliziumsubstrat, eine auf dem Siliziumsubstrat angeordnete Oxidschicht und eine auf der Oxidschicht angeordnete Siliziumschicht aufweist;
die Siliziumschicht Einkristall-Silizium ist; und
der Wellenleiter in der Siliziumschicht ist.

9. Abstimmbarer Laser nach Anspruch 8, wobei das erste Wellenlängen-selektive Element (12) und das zweite Wellenlängen-selektive Element (14) in der Siliziumschicht angeordnet sind.

10. Abstimmbarer Laser nach Anspruch 1, der ferner einen Halbleiter/ Halbleiteranschluss zwischen dem Verstärkungsmedium (20) und dem Substrat (22) enthält.

11. Verfahren zum Betreiben eines abstimmbaren Lasers (10), das Verfahren enthaltend:

Abstimmen eines ersten modulierten Gitter-Reflektors (12), wobei der erste modulierte Gitter-Reflektor (12) **gekennzeichnet ist durch** ein erstes Reflexionsspektrum, das eine erste Vielzahl von Reflexions-Peaks einschließt,;
Generieren optischer Emission eines Verstärkungsmediums (20), wobei:

das Verstärkungsmedium an ein Substrat (22), das Siliziummaterial aufweist, gekoppelt ist;

sich das Verstärkungsmedium in einem vertieften Bereich des Siliziummaterials befindet; und

das Verstärkungsmedium ein Verbindungs-Halbleiter-Material enthält;

optisches Koppeln Lichts vom Verstärkungsgerät zu einem Wellenleiter unter Benutzung eines Brechungsindex-angepassten Bereichs, der mit Brechungsindexangepasstem Material gefüllt ist, wobei der Wellenleiter in dem Substrat angeordnet ist;
Wellenleiten der optischen Emission, um eine optische Kopplung zu passieren;
Reflexion eines Teils der optischen Emission, der eine spektrale Bandbreite hat, die durch eine Überlappung eines aus der ersten Vielzahl Reflexions-Peaks und eines aus der zweiten Vielzahl Reflexions-Peaks definiert wird;
Verstärkung des Teils der optischen Emission im Verstärkungsmedium (20); und Transmission eines Teils der verstärkten optischen Emission durch einen Ausgangsspiegel.

12. Verfahren nach Anspruch 11, wobei der erste modulierte Gitter-Reflektor (12) ein Superstruktur-Gitter, **gekennzeichnet durch** einen ersten Wellenlängenabstand zwischen Moden, enthält.

13. Verfahren nach Anspruch 12, wobei der zweite modulierte Gitter-Reflektor (12) ein Superstruktur-Gitter, **gekennzeichnet durch** einen zweiten Wellenlängenabstand zwischen Moden, welche anders ist als der erste Wellenlängenabstand zwischen Moden, enthält.

14. Verfahren nach Anspruch 11, wobei:

der erste modulierte Gitter-Reflektor (12) ein erstes Brechungsindex-Einstellungsgerät enthält; und
der zweite modulierte Gitter-Reflektor (14) ein zweites Brechungsindex-Einstellungsgerät enthält.

15. Verfahren nach Anspruch 11, das ferner Phaseneinstellung der optischen Emission enthält.

**Revendications**

1. Laser accordable (10) comprenant :

un substrat (22) comprenant un matériau de silicium ;
un milieu amplificateur (20) couplé au substrat, le milieu amplificateur étant dans une région évidée du matériau de silicium et le milieu amplificateur comportant un matériau semiconducteur composé ;
un guide d'ondes disposé dans le substrat (22) et couplé optiquement au milieu amplificateur (20) ;
un premier élément sélectif de longueur d'onde (12) **caractérisé par** un premier spectre de réflexion et disposé dans le substrat (22) ;
un second élément sélectif de longueur d'onde (14) **caractérisé par** un second spectre de réflexion et disposé dans le substrat (22) ; et
un coupleur optique disposé dans le substrat (22) et joignant le guide d'ondes, le premier élément sélectif de longueur d'onde (12) et le second élément sélectif de longueur d'onde (14) ;
une région d'adaptation d'indice (18) remplie de matériau d'adaptation d'indice entre le milieu amplificateur (20) et le guide d'ondes ; et
un miroir de sortie.

2. Laser accordable selon la revendication 1, dans lequel :

le premier élément sélectif de longueur d'onde (12) comprend un premier réflecteur à réseau modulé ; et
le second élément sélectif de longueur d'onde (14) comprend un second réflecteur à réseau modulé.

3. Laser accordable selon la revendication 2, dans lequel le premier réflecteur à réseau modulé (12) comprend un réseau de superstructure **caractérisé par** un premier espacement de longueurs d'onde entre modes.

4. Laser accordable selon la revendication 3, dans lequel le second réflecteur à réseau modulé (14) comprend un réseau de superstructure **caractérisé par** un second espacement de longueurs d'onde entre modes différent du premier espacement de longueurs d'onde entre modes.

5. Laser accordable selon la revendication 1, dans lequel :

le premier élément sélectif de longueur d'onde (12) comprend un premier dispositif de réglage d'indice de réfraction ; et
le second élément sélectif de longueur d'onde (14) comprend un second dispositif de réglage d'indice de réfraction.

6. Laser accordable selon la revendication 5, dans lequel le premier dispositif de réglage d'indice de réfraction comprend un dispositif thermique (26) ; et
le second dispositif de réglage d'indice de réfraction comprend un dispositif thermique (27) ; et/ou

le premier élément sélectif de longueur d'onde comprenant en outre un premier capteur de température (28) ; et
le second élément sélectif de longueur d'onde comprenant en outre un second capteur de température (29).

7. Laser accordable selon la revendication 1, dans lequel le laser accordable (10) comprend en outre une section de réglage de phase couplée optiquement entre le guide d'ondes et le coupleur optique ; et/ou le laser accordable comprenant en outre une seconde section de réglage de phase permettant de modifier une phase optique dans au moins l'un du premier élément sélectif de longueur d'onde (12) ou du second élément sélectif de longueur d'onde (14).

8. Laser accordable selon la revendication 1, dans lequel :

le matériau de silicium comprend une plaquette de silicium sur isolant présentant un substrat de silicium, une couche d'oxyde disposée sur le substrat de silicium et une couche de silicium disposée sur la couche d'oxyde ;
la couche de silicium est du silicium monocristallin ; et
le guide d'ondes se trouve dans la couche de silicium.

9. Laser accordable selon la revendication 8, dans lequel le premier élément sélectif de longueur d'onde (12) et le second élément sélectif de longueur d'onde (14) sont disposés dans la couche de silicium.

10. Laser accordable selon la revendication 1, comprenant en outre un semiconducteur/une interface de semiconducteur entre le milieu amplificateur (20) et le substrat (22).

11. Procédé d'utilisation d'un laser accordable (10), le procédé comprenant :

l'accord d'un premier réflecteur à réseau modulé (12), le premier réflecteur à réseau modulé étant **caractérisé par** un premier spectre de réflexion comportant une première pluralité de pics de réflexion ;
l'accord d'un second réflecteur à réseau modulé (14), le second réflecteur à réseau modulé étant **caractérisé par** un second spectre de réflexion comportant une seconde pluralité de pics de réflexion ;
la génération d'une émission optique à partir d'un milieu amplificateur (20) :

le milieu amplificateur étant couplé à un substrat (22) présentant un matériau de silicium ;

le milieu amplificateur se trouvant dans une région évidée du matériau de silicium ; et

le milieu amplificateur comprenant un matériau semiconducteur composé ;

le couplage optique de la lumière provenant du milieu amplificateur à un guide d'ondes à l'aide d'une région d'adaptation d'indice remplie de matériau d'adaptation d'indice, le guide d'ondes étant disposé dans le substrat ;

le guidage d'ondes de l'émission optique pour qu'elle traverse un coupleur optique ;

la réflexion d'une partie de l'émission optique présentant une largeur de bande spectrale définie par une superposition d'un pic de la première pluralité de pics de réflexion et d'un pic de la seconde pluralité de pics de réflexion ;

l'amplification de la partie de l'émission optique dans le milieu amplificateur (20) ; et

la transmission d'une partie de l'émission optique amplifiée à travers un miroir de sortie.

12. Procédé selon la revendication 11, dans lequel le premier réflecteur à réseau modulé (12) comprend un réseau de superstructure **caractérisé par** un premier espacement de longueurs d'onde entre modes.

13. Procédé selon la revendication 12, dans lequel le second réflecteur à réseau modulé (14) comprend un réseau de superstructure **caractérisé par** un second espacement de longueurs d'onde entre modes différents du premier espacement de longueurs d'onde entre modes.

14. Procédé selon la revendication 11, dans lequel :

le premier réflecteur à réseau modulé (12) comprend un premier dispositif de réglage d'indice de réfraction ; et

le second réflecteur à réseau modulé (14) comprend un second dispositif de réglage d'indice de réfraction.

15. Procédé selon la revendication 11, comprenant en outre le réglage de phase de l'émission optique.

FIG. 1A

**FIG. 1B**

**FIG. 1C**

Gain Chip 20

222 — 210

220

Si layer

Oxide layer

SOI Wafer

Si Substrate

**FIG. 2A**

240

230

Gain Chip 20

225

Si layer

Oxide layer

Si Substrate

**FIG. 2B**

**FIG. 3A**

**FIG. 3B**

**FIG. 3C**

TE pol.
$n_H = 3.3757$

TM pol.
$n_H = 3.3733$

**FIG. 3D**

**FIG. 3E**

TE pol.
$n_L = 3.3709$

TM pol.
$n_L = 3.3705$

**FIG. 3F**

**FIG. 3G**

FIG. 4A

FIG. 4B

*FIG. 4C*

*FIG. 4D*

*FIG. 5A*

**FIG. 5B**

600

Tune a first wavelength selected device ⸺ 610

↓

Tune a second wavelength selected device ⸺ 612

↓

Generate optical emission from a gain medium comprising a compound semiconductor material ⸺ 614

↓

Waveguide the optical emission to pass through an optical coupler ⸺ 616

↓

Reflect a portion of the optical emission having a spectral bandwidth defined by an overlap of one of the first plurality of reflectance peaks and one of the second plurality of reflectance peaks ⸺ 618

↓

Amplify the portion of the optical emission in the gain medium ⸺ 620

↓

Transmit a portion of the amplified optical emission through an output mirror ⸺ 622

*FIG. 6*

InGaAs

Si

**FIG. 7**

710

714
712

716
718

720

**FIG. 8**

**FIG. 9**

Interconnect Metal

Planarizing Material

810

Silicon — 808

— 807

Bond 1    Bond 2    Oxide

805 {

— 806

Silicon Handle

**FIG. 10**

820

Interconnect Metal          5B          Planarizing Material

808 ─                                                    ─ Silicon
807 ─                                                    ─ Oxide

Bond 1          Bond 2

806 ─

Silicon Handle

**FIG. 11A**

832 ─

834 ─          Bond 1                          ─ 820

                                              5C

830 ─

                                    ─ 808

**FIG. 11B**

Compound Semiconductor
Device

820

Interface Layer ─ ─ 840
                        ─ 808
Silicon

**FIG. 11C**

Compound
Semiconductor Device

820

Bond 1

Bond 2'

6B

808

Silicon

**FIG. 12A**

Compound
Semiconductor Device

840'

Direct
Semiconductor
Bond 842

Silicon

**FIG. 12B**

900

Provide a substrate comprising a silicon layer — 910

Provide a compound semiconductor device — 912

Form a metal-semiconductor bond at a first portion of a bonding region between the silicon layer and the compound semiconductor device — 914

Form an interface assisted bond at a second portion of the bonding region between the silicon layer and the compound semiconductor device — 916

**FIG. 13**

950

Provide SOI substrate —— 960

↓

Provide compound semiconductor device —— 962

↓

Pattern metals in a first bond region —— 964

↓

Perform surface treatment —— 966

↓

Position compound semiconductor device on SOI substrate —— 968

↓

Apply heat and pressure to join compound semiconductor device to SOI substrate —— 970

*FIG. 14*

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 61251132
- US 61251143 B
- US 20040037342 A1
- US 20090225796 A1